Europäisches Patentamt

European Patent Office

Office européen des brevets

(19)

(11) Veröffentlichungsnummer : **0 105 150**
**B1**

(12) # EUROPÄISCHE PATENTSCHRIFT

(45) Veröffentlichungstag der Patentschrift :
03.12.86

(51) Int. Cl.⁴ : **H 05 K 7/14**

(21) Anmeldenummer : 83108099.9

(22) Anmeldetag : 17.08.83

(54) **Führungsschiene für elektronische Baugruppenträger.**

(30) Priorität : 30.09.82 CH 5778/82

(43) Veröffentlichungstag der Anmeldung :
11.04.84 Patentblatt 84/15

(45) Bekanntmachung des Hinweises auf die Patenterteilung : 03.12.86 Patentblatt 86/49

(84) Benannte Vertragsstaaten :
AT BE CH DE FR GB IT LI NL SE

(56) Entgegenhaltungen :
DE-B- 1 271 793
FR-A- 1 576 065
FR-A- 2 225 916

(73) Patentinhaber : CONTRAVES AG
Schaffhauserstrasse 580
CH-8052 Zürich (CH)

(72) Erfinder : Hänseler, Urs
Rütistrasse 10
CH-8122 Pfaffhausen (CH)
Erfinder : Meier, Urs
Hubring 44
CH-8303 Bassersdorf (CH)
Erfinder : Muther, Franz
Nordstrasse 408
CH-8037 Zürich (CH)

## Beschreibung

Die Erfindung bezieht sich auf eine Führungsschiene für elektronische Baugruppenträger zur steckbaren Befestigung an den Tragleisten eines Traggestells, wobei an dem einen Ende des im wesentlichen U-förmigen Führungsschienen-Körpers ein erstes Rasterorgan und an dem anderen Ende ein zweites Rasterorgan angeordnet ist, die mit federnd ausgebildeten Rasterzapfen in entsprechend im Abstand zueinander in den Tragleisten angeordnete und durch Stege getrennte Ausnehmungen eingreifen. Solche Führungsschiene sind bekannt aus den Schriften DE-B-1 271 793 und FR-A-1 578 065.

Aus der DE-A 2 554 106 ist eine Führungsschiene bekannt, welche zur steckbaren Befestigung an entsprechend zugeordnete Querschienen eines Traggestells am vorderen und am hinteren Ende mit einem Halteelement versehen ist, das federnd in entsprechend in den Querschienen vorgesehene Ausnehmungen eingreift. Das einzelne, nach unten abgewinkelt am Schienenkörper angeordnete Halteelement umfasst zwei im Abstand zueinander angeordnete Federelemente, die im wesentlichen parallel zur Querschienen-Ausnehmung federnd ausgebildet sind. Zwischen den Federelementen der einzelnen Halteelemente ist zur Erreichung des erforderlichen Toleranzausgleichs zusätzlich ein aus zwei federnd ausgebildeten Stegen gebildetes Führungselement vorgesehen, welches in zusätzliche Oeffnungen der Querschienen eingreift.

Der Erfindung liegt die Aufgabe zugrunde, eine Führungsschiene der eingangs genannten Art derart weiterzubilden, dass der durch die Ausnehmungen in den Tragleisten vorgegebene Abstand der einzelnen, in Reihe in dem Traggestell angeordneten Führungsschienen im wesentlichen halbiert und somit eine optimale Packungsdichte der Baugruppenträger in dem Traggestell erreicht wird.

Erfindungsgemäss wird diese Aufgabe dadurch gelöst, dass zwischen den Rasterzapfen der beiden Rasterorgane je ein wahlweise in die Ausnehmungen einschiebbar oder auf die zwischen den Ausnehmungen angeordneten Stege aufsteckbar ausgebildetes Teilungselement angeordnet ist. Nach einem weiteren Merkmal der Erfindung ist zur steckbaren Halterung eines Buchsen-Steckerelements an der inneren Rückseite des Traggestells am hinteren Ende der Führungsschiene ein mit einem Zapfen versehenes Halteorgan vorgesehen.

Weitere Merkmale der Erfindung ergeben sich aus der folgenden Beschreibung in Verbindung mit der Zeichnung und den Patentansprüchen.

Die Erfindung wird anhand von Zeichnungen beschrieben. In den Zeichnungen zeigt :

Figur 1 eine in Seitenansicht und teilweise im Schnitt dargestellte Führungsschiene für einen in ein Traggestell einschiebbaren Baugruppenträger,

Figur 2 die in Draufsicht und teilweise im Schnitt gemäss der Linie II-II in Fig. 1 dargestellte Führungsschiene,

Figur 3 eine in Pfeilrichtung X dargestellte Stirnansicht mit dem vorderen Teilstück der Führungsschiene,

Figur 4 eine in Pfeilrichtung Y dargestellte Rückansicht mit dem hinteren zur Halterung eines Buchsen-Steckerelements ausgebildeten Teilstück der Führungsschiene,

Figur 5 eine perspektivische Schnittansicht mit dem in demontiertem Zustand dargestellten, in eine erste Tragleiste einsteckbaren Teilstück der Führungsschiene,

Figur 6 eine perspektivische Schnittansicht mit dem in demontiertem Zustand dargestellten hinteren, in eine zweite Tragleiste einsteckbaren Teilstück der Führungsschiene,

Figur 7 die in Schnittansicht und in grösserem Massstab dargestellte Tragleiste mit der in einer ersten Stellung eingesteckten Führungsschiene, und

Figur 8 die Tragleiste gemäss Fig. 7 mit der in einer zweiten Stellung eingesteckten Führungsschiene.

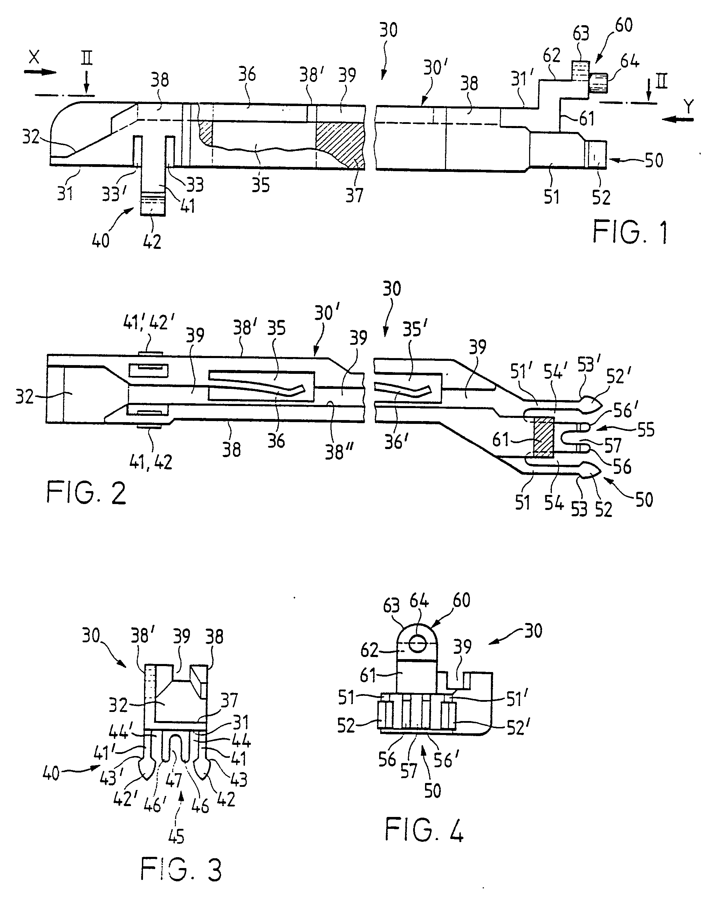

In Fig. 1 ist mit 30 eine in Seitenansicht und in Fig. 2 in Draufsicht und teilweise im Schnitt gemäss der Linie II-II in Fig. 1 dargestellte Führungsschiene bezeichnet, welche einen aus Seitenwänden 38, 38' und einem Boden 37 im wesentlichen U-förmig ausgebildeten Profilquerschnitt hat. Im vorderen Bereich der Führungsschiene 30 ist an der Unterseite 31 ein rechtwinkelig nach unten orientiertes, erstes Rasterorgan 40 und im hinteren Bereich ist ein in Längsrichtung sowie in Fortsetzung des Führungsschienenkörpers 30' orientiertes, zweites Rasterorgan 50 angeformt. Weiterhin ist im hinteren Bereich ein rechtwinkelig nach oben orientiertes Halteorgan 60 vorgesehen.

Die mit einer in Längsrichtung verlaufenden Nut 39 versehene Führungsschiene 30 ist von mehreren, in Abständen zueinander angeordneten Ausnehmungen 35, 35' durchdrungen, in welche, wie in Fig. 2 dargestellt, je ein an der Seitenwand 38' angeformtes Federelement 36, 36' hineinragt. Ein in den Figuren 1 bis 4 nicht dargestellter Baugruppenträger 20 wird in die Nut 39 eingeschoben und mittels der Federelemente 36, 36' gegen die Innenseite 38'' der Seitenwand 38 gedrückt. Das im vorderen Bereich an der Unterseite 31 der Führungsschiene 30 angeformte erste Rasterorgan 40 umfasst zwei nach unten abgewinkelte und im Abstand zueinander angeordnete Schenkel 41, 41', an welchen je ein Rasterzapfen 42, 42' angeformt ist. Der Uebergang vom Schenkel 41, 41' zu dem Rasterzapfen 42, 42' wird auf beiden Seiten, wie in Fig. 3 näher dargestellt, jeweils durch eine Schräge 43, 43' gebildet. Die beiden, als Verlängerung an den Seitenwänden 38, 38' angeformten und nach unten gerichteten Rasterorgane sind durch Schlitze 33, 33' von den Seitenwänden 38, 38' getrennt und dadurch quer zur Längsrichtung der Führungsschiene 30 federnd ausgebildet. In Fig. 3 ist die im wesentlichen aus den Seitenwänden 38, 38' und dem Boden 37 gebildete Führungsschiene 30 in Stirnansicht gemäss Pfeilrichtung X dargestellt und man erkennt eine, wie in Fig. 1 näher dargestellt, als Schräge ausgebildete Einführungspartie 32, die Nut 39 für den Baugruppenträger sowie das aus den Schenkeln 41, 41' und den beiden im Profilquerschnitt im wesentlichen tropfenförmig ausgebildeten Rasterzapfen 42, 42' gebildete erste Rasterorgan 40. Zwischen den beiden Schenkeln 41, 41' des Rasterorgans 40 ist parallel zu den Schenkeln ein Teilungselement 45 angeordnet, welches zwei durch eine Tasche 47 voneinander getrennte Zapfen 46, 46' hat. Zwischen den beiden Zapfen 46, 46' des Teilungselements 45 und den Schenkeln 41, 41' des Rasterorgans 40 ist jeweils ein Spalt 44, 44' vorgesehen, wodurch auch die Zapfen 46, 46' quer zur Längsrichtung der Führungsschiene 30 federnd ausgebildet sind. Das im hinteren Bereich, in Fortsetzung des Führungsschienenkörpers 30' im wesentlichen an den Seitenwänden angeformte zweite Rasterorgan 50 umfasst die Teile 51, 51' und 52, 52' mit den Schrägen 53, 53' sowie ein Teilungselement 55 mit den Teilen 56, 56', welche durch Spalten 54, 54' und durch die Tasche 57 voneinander getrennt sind. Das zweite Rasterorgan 50 ist im wesentlichen gleich dem ersten Rasterorgan 40 ausgebildet und die Teile 51, 51' des zweiten Rasterorgans 50 sowie die Teile 56, 56' des Teilungselements 55 sind ebenfalls quer zur Längsrichtung der Führungsschiene 30 federnd ausgebildet.

Wie in Fig. 1 weiterhin dargestellt, ist im hinteren Bereich an der Oberseite 31' der Führungsschiene 30 das Halteorgan 60 angeformt, welches einen ersten und einen zweiten nach oben abgewinkelten Schenkel 61, 63, einen in parallelem Abstand zur Oberseite 31' orientierten Steg 62 sowie einen am Schenkel 63 angeformten Zapfen 64 umfasst.

In Fig. 4 ist die Führungsschiene 30 in Rückansicht gemäss Pfeilrichtung Y dargestellt und man erkennt die Nut 39, das aus den Teilen 51, 51' und 52, 52' sowie 56, 56' gebildete zweite Rasterorgan 50 sowie das aus den Teilen 61, 62, 63 und 64 gebildete Halteorgan 60.

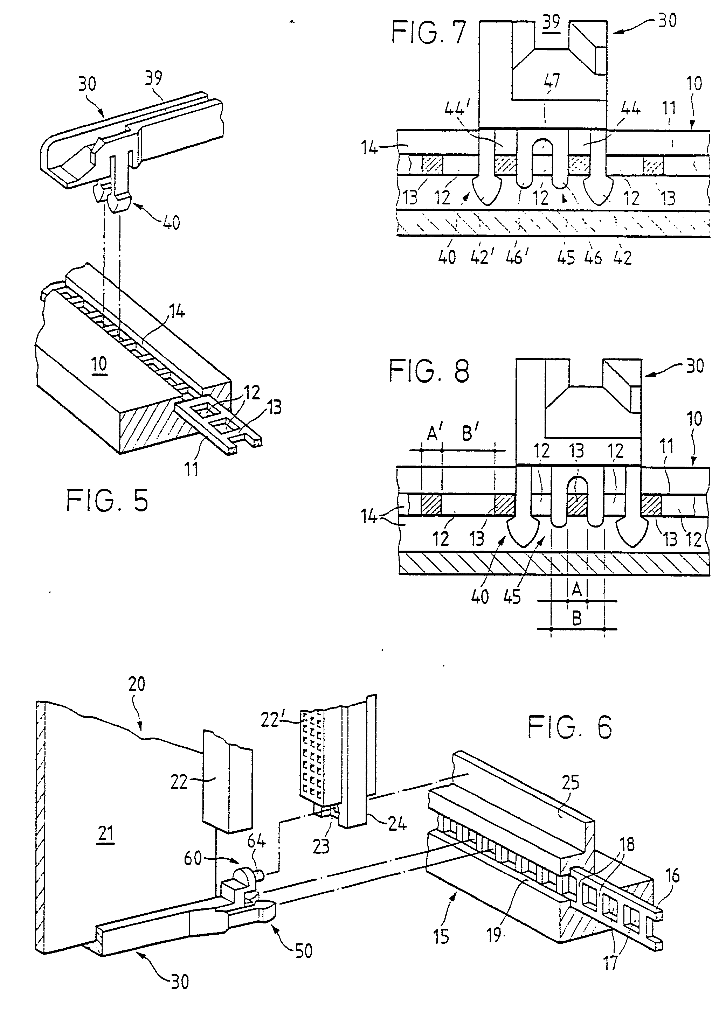

In Fig. 5 ist in demontiertem Zustand und in perspektivischer Schnittansicht eine vordere Tragleiste 10 eines nicht näher dargestellten Traggestells für die Baugruppenträger 20 sowie das vordere Teilstück der Führungsschiene 30 mit der Nut 39 und dem ersten Rasterorgan 40 dargestellt. Die Tragleiste 10 hat auf der der Führungsschiene 30 zugewandten Seite eine in Längsrichtung orientierte Aussparung 14, in welche ein gegen Herausfallen gesicherter Blechstreifen 11 eingeschoben ist. Der Blechstreifen weist eine Vielzahl im Abstand zueinander angeordnete Ausnehmungen 12 auf, welche jeweils durch einen Steg 13 voneinander getrennt sind.

In Fig. 6 ist in demontiertem Zustand und in perspektivischer Schnittansicht eine hintere Tragleiste 15 des nicht dargestellten Traggestells für die Baugruppenträger 20 sowie das hintere Teilstück der Führungsschiene 30 mit dem zweiten Rasterorgan 50 und dem Halteorgan 60 dargestellt. Die Tragleiste 15 weist auf der der Führungsschiene 30 zugewandten Seite eine in Längsrichtung orientierte Aussparung 19 auf, in welche ein gegen Herausfallen gesicherter Blechstreifen 16 eingeschoben ist. Der Blechstreifen ist mit einer Vielzahl im Abstand zueinander angeordneter Ausnehmungen 17 versehen. Die Ausnehmungen 17 sind jeweils durch einen Steg 18 voneinander getrennt. Weiterhin erkennt man in Fig. 6 ein Teilstück einer Leiterplatte 21 und ein Teilstück eines Stiften-Steckerelements 22 des in die Führungsschiene 30 eingeschobenen Baugruppenträgers 20 sowie ein Teilstück eines dem Stiften-Steckerelement 22 entsprechend zugeordneten Buchsen-Steckerelements 22'.

Der Zusammenbau der einzelnen Teile erfolgt im wesentlichen wie in Fig. 5 und Fig. 6 durch die strichpunktierten Linien dargestellt, wobei gemäss Fig. 5 das eine Ende der Führungsschiene 30 mit dem ersten Rasterorgan 40 mit dem Blechstreifen 11 der Tragleiste 10 und gemäss Fig. 6 das andere Ende der Führungsschiene 30 mit dem zweiten Rasterorgan 50 mit dem Blechstreifen 16 der Tragleiste 15 einrastend in Eingriff gebracht wird. Bei dem letzten Vorgang durchdringt der Zapfen 64 des Halteorgans 60 eine in dem Buchsen-Steckerelement 22' vorgesehene Ausnehmung 23, so dass das Buchsen-Steckerelement gleichzeitig mit dem leistenartigen Ansatz 24 fest anliegend gegen eine Anlagefläche 25 der Tragleiste 15 gedrückt wird.

An dieser Stelle sei darauf hingewiesen, dass die beiden Rasterorgane 40, 50 mit den Teilungselementen 45, 55 im wesentlichen gleich ausgebildet sind.

In Fig. 7 ist als Beispiel und in grösserem Massstab eine erste Stellung der eingerasteten Führungsschiene 30 dargestellt und man erkennt die in Schnittansicht dargestellte Tragleiste 10 mit der in nicht näher dargestellter Weise stufenförmig abgesetzt ausgebildeten Aussparung 14 sowie den in der Aussparung 14 angeordneten und im Schnitt dargestellten Blechstreifen 11 mit den Ausnehmungen 12 und Stegen 13. Weiterhin erkennt man die in Stirnansicht dargestellte Führungsschiene 30 mit dem vorderen Rasterorgan 40 und dem Teilungselement 45. In der in Fig. 7 dargestellten Stellung ist das Teilungselement 45 mit den beiden Zapfen 46, 46' in der Ausnehmung 12 angeordnet, während die Rasterzapfen 42, 42' des Rasterorgans 40 federnd über zwei im Abstand zueinander angeordnete Stege 13 des Blechstreifens 11 greifen, so dass die Stege 13 zwischen der Innenseite der Rasterzapfen 42, 42' und der Aussenseite des Teilungselements 45 angeordnet sind.

In Fig. 8 ist eine zweite Stellung der Führungsschiene 30 dargestellt und man erkennt die Tragleiste 10 mit der Aussparung 14, den Blechstreifen 11 mit den Ausnehmungen 12 und Stegen 13 sowie die in Stirnansicht dargestellte Führungsschiene mit dem Rasterorgan 40 und dem Teilungselement 45. In dieser Stellung ist das Teilungselement 45 mit der Tasche 47 auf den einen Steg 13 aufgesteckt, während die Rasterzapfen 42, 42' mit der Aussenseite federnd zwischen drei im Abstand zueinander angeordnete und durch die Ausnehmungen 12 getrennte Stege 13 des Blechstreifens 11 eingreifen.

Der die Tasche 47 oder 57 bildende innere Abstand A der Teilungselemente 45 oder 55 muss mindestens so gross wie die Breite A' der Stege 13 oder 18 von den Blechstreifen 11 oder 16 sein. Weiterhin darf die äussere Breite B der Teilungselemente 45 oder 55 nicht grösser als die lichte Breite B' der Ausnehmungen 12 oder 17 in den Blechstreifen 11 oder 16 sein.

Wie aus Fig. 7 erkennbar, ist es erforderlich, dass der innere Abstand zwischen den Schenkeln 41, 41' und 51, 51' der beiden Rasterorgane 40, 50 mindestens so gross wie der Abstand von zwei durch eine Ausnehmung 12 voneinander getrennte Stege 13 ist.

Wie aus Fig. 8 erkennbar, ist es ferner erforderlich, dass der innere Abstand von zwei nebeneinander liegenden und durch einen Steg 13 voneinander getrennten Ausnehmungen 12 mindestens so gross wie der äussere Abstand der Schenkel 41, 41' und 51, 51' der beiden Rasterorgane 40, 50 ist.

Die erfindungsgemässe Führungsschiene 30 mit den Teilungselementen 45, 55 ermöglicht gegenüber den bekannten Führungsschienen eine wesentlich engere Anordnung der Baugruppenträger 20 in dem Traggestell sowie eine schraubenlose Befestigung der Führungsschiene und des Buchsen-Steckerelements 22' an den Tragleisten 10, 15. Vorteilhaft wirken ferner die mit den Tragleisten im Eingriff stehenden Teilungselemente 45, 55 auf die Stabilität der Führungsschienen und somit auch auf die Baugruppenträger, wobei Versuche gezeigt haben, dass die beschriebene Führungsschiene 30 eine rüttelsichere, militärtaugliche Befestigung der Baugruppenträger in dem Traggestell gewährleistet.

**Patentansprüche**

1. Führungsschiene (30) für elektronische Baugruppenträger (20) zur steckbaren Befestigung an den Tragleisten (10, 15) eines Traggestells, wobei an dem einen Ende des im wesentlichen U-förmigen Führungsschienen-Körpers (30') ein erstes Rasterorgan (40) und an dem anderen Ende ein zweites Rasterorgan (50) angeordnet ist, die mit federnd ausgebildeten Rasterzapfen (42, 42' und 52, 52') in entsprechend im Abstand zueinander angeordnete und durch Stege (13, 18) getrennte Ausnehmungen (12, 17) eingreifen, dadurch gekennzeichnet, dass zwischen den Rasterzapfen (42, 42' und 52, 52') der beiden Rasterorgane (40, 50) je ein wahlweise in die Ausnehmungen (12, 17) einschiebbar oder auf die zwischen den Ausnehmungen angeordneten Stege (13, 18) aufsteckbar ausgebildetes Teilungselement (45, 55) angeordnet ist.

2. Führungsschiene nach Anspruch 1, dadurch gekennzeichnet, dass das einzelne Teilungselement (45, 55) einen zu einem in den Tragleisten (10, 15) angeordneten Blechstreifen (11, 16) hin offenen, im wesentlichen U-förmigen Profilquerschnitt hat, und dass der Blechstreifen (11, 16) die durch die Stege (13, 18) getrennten Ausnehmungen (12, 17) aufweist.

3. Führungsschiene nach Anspruch 1 und 2, dadurch gekennzeichnet, dass das Teilungselement (45, 55) zwei im Abstand zueinander angeordnete und je durch eine Tasche (47, 57) voneinander getrennte, federnd ausgebildete Zapfen (46, 46' und 56, 56') aufweist.

4. Führungsschiene nach einem der vorhergehenden Ansprüche, dadurch gekennzeichnet, dass der die Tasche (47, 57) bildende innere Abstand (A) mindestens so gross wie die Breite (A') der Stege (13 oder 18) und die äussere Breite (B) der Teilungselemente (45, 55) nicht grösser als die Breite (B') der Ausnehmungen (12 oder 17) ist.

5. Führungsschiene nach einem der vorhergehenden Ansprüche, dadurch gekennzeichnet, dass der innere Abstand zwischen den Schenkeln (41, 41' und 56, 56') der beiden Rasterorgane (40, 50) mindestens so gross wie der äussere Abstand von zwei im Abstand zueinander angeordneten und durch eine Ausnehmung (12 oder 17) voneinander getrennten Stegen (13 oder 18) ist.

6. Führungsschiene nach einem der vorhergehenden Ansprüche, dadurch gekennzeichnet, dass der innere Abstand zwei im Abstand zueinander angeordneter und jeweils durch einen Steg (13 oder 18) voneinander getrennter Ausnehmungen (12 oder 17) mindestens so gross wie der äussere Abstand der Schenkel (41, 41' und 56, 56') der beiden Rasterorgane (40, 50) ist.

7. Führungsschiene nach Anspruch 1, dadurch gekennzeichnet, dass an dem hinteren Ende der Führungsschiene (30) ein mit einem Zapfen (64) versehenes Halteelement (60) angeordnet ist.

8. Führungsschiene nach einem der vorhergehenden Ansprüche, dadurch gekennzeichnet, dass das vordere, erste Rasterorgan (40) mit dem ersten Teilungselement (45) rechtwinkelig nach unten, das hintere, zweite Rasterorgan (50) mit dem zweiten Teilungselement (55) im wesentlichen in Längsrichtung und das Halteorgan (60) rechtwinkelig nach oben orientiert an dem Führungskörper (30') angeformt ist.

**Claims**

1. Guide rail (30) for an electronic component carrier (20), for plug-in securing to the carrier strips (10, 15) of a carrier frame, wherein on one end of the substantially U-shaped guide rails body (30') there is arranged a first grid element (40) and on the other end a second grid element (50), which engage with resiliently constructed grid pins (42, 42' and 52, 52') in recesses (12, 17)

arranged appropriately at a distance from each other and separated by crosspieces (13, 18), characterised in that between the grid pins (42, 42' and 52, 52') of the two grid elements (40, 50) there is arranged a dividing element (45, 55) which can optionally be inserted into the recesses (12, 17) or can be placed on the crosspieces (13, 18) arranged between the recesses.

2. Guide rail according to claim 1, characterised in that the individual dividing element (45, 55) has a substantially U-shaped profiled cross section open towards a sheet metal strip (11, 16) arranged in the carrier strips (10, 15), and in that the sheet metal strip (11, 16) has the recesses (12, 17) separated by the crosspieces (13, 18).

3. Guide rail according to claim 1 and 2, characterised in that the dividing element (45, 55) has two resiliently constructed pins (46, 46' and 56, 56') spaced apart from each other and separated from each other by a pocket (47, 57).

4. Guide rail according to one of the preceding claims, characterised in that the inner clearance (A) forming the pocket (47, 57) is at least as large as the width (A') of the crosspieces (13 or 18), and the outer width (B) of the dividing elements (45, 55) is not greater than the width (B') of the recesses (12 or 17).

5. Guide rail according to one of the preceding claims, characterised in that the inner space between the limbs (41, 41' and 56, 56') of the two grid elements (40, 50) is at least as large as the outer space of two crosspieces (13 or 18) arranged at a distance from each other and separated from each other by a recess (12 or 17).

6. Guide rail according to one of the preceding claims, characterised in that the inner space of two recesses (12 or 17) arranged at a distance from each other and separated from each other respectively by a crosspiece (13 or 18) is at least as large as the outer space of the limbs (41, 41' and 56, 56') of the two grid elements (40, 50).

7. Guide rail according to claim 1, characterised in that on the rear end of the guide rail (30) there is arranged a holding element (60) provided with a pin (64).

8. Guide rail according to one of the preceding claims, characterised in that the front first grid element (40) is formed with the first dividing element (45) at right angles in a downwards direction, the rear second grid element (50) is formed with the second dividing element (55) substantially in the longitudinal direction and the holding element (60) is directed upwardly at right angles on the guide body (30').

**Revendications**

1. Glissière (30) pour support (20) de modules électroniques permettant la fixation par enfichage sur des barres porteuses (10, 15) d'un châssis porteur, un premier organe d'encliquetage (40) étant disposé à l'une des extrémités du corps essentiellement en forme de U (30') de la glissière, tandis qu'à l'autre extrémité est disposé un deuxième organe d'encliquetage (50) ces organes venant en prise avec des broches d'encliquetage élastiques (42, 42' et 52, 52') dans des évidements (12, 17) disposés de façon appropriée à une certaine distance les uns des autres et séparés par des traverses (13, 18), glissière caractérisée en ce qu'entre les broches d'encliquetage (42, 42' et 52, 52') des deux organes d'encliquetage (40, 50) est respectivement disposé un élément de division (45, 55) prévu pour être introduit à volonté dans les évidements (12, 17) ou bien pour être emboîté sur les traverses (13, 18) disposées entre les évidements.

2. Glissière selon la revendication 1, caractérisé en ce que l'élément de division individuel (45, 55) a une section transversale essentiellement profilée en forme de U ouvert en direction d'une bande de tôle (11, 16) disposée dans les barres porteuses (10, 15), la bande de tôle (11, 16) comportant les évidements (12, 17) séparés par les traverses (13, 18).

3. Glissière selon les revendications 1 et 2, caractérisée en ce que l'élément de division (45, 55) comporte deux broches élastiques (46, 46' et 56, 56') disposées à une certaine distance l'une de l'autre et séparées par une poche (47, 57).

4. Glissière selon une des précédentes revendications, caractérisée en ce que la distance interne (A) constituant la poche (47, 57) est au moins aussi grande que la largeur (A') de la traverse (13 ou 18) tandis que la largeur externe (B) des éléments de division (45, 55) n'est pas supérieure à la largeur (B') des évidements (12 ou 17).

5. Glissière selon une des précédentes revendications, caractérisée en ce que la distance interne entre les branches (41, 41' et 51, 51') des deux organes d'encliquetage (40, 50) est au moins aussi grande que la distance externe de deux traverses (13 ou 18) disposées à une certaine distance l'une de l'autre et séparées l'une de l'autre par un évidement (12 ou 17).

6. Glissière selon une des précédentes revendications, caractérisée en ce que la distance interne de deux évidements (12 ou 17) disposés à une certaine distance l'un de l'autre et respectivement séparés l'un de l'autre par une traverse (13 ou 18, est au moins aussi grande que la distance externe des branches (41, 41' et 51, 51') des deux organes d'encliquetage (40, 50).

7. Glissière selon la revendication 1, caractérisée en ce qu'à l'extrémité arrière de la glissière (30) est disposé un élément de maintien (60) muni d'un téton (64).

8. Glissière selon une des précédentes revendications, caractérisée en ce que le premier organe d'encliquetage (40), antérieur, et le premier élément de division (45) sont formés sur le corps (30') de la glissière en étant orientés à angle droit vers le bas, le deuxième organe d'encliquetage (50), postérieur, et le second élément de division (55) sont formés sur le corps (30') de la glissière en étant orientés essentiellement en direction longitudinale, et l'organe de maintien (60) est formé sur le corps (30') de la glissière en étant orienté à angle droit vers le haut.

FIG. 1

FIG. 2

FIG. 3

FIG. 4

FIG. 7

FIG. 5

FIG. 8

FIG. 6